**Europäisches Patentamt**

**European Patent Office**

**Office européen des brevets**

Publication number: **0 361 533**

**A2**

# EUROPEAN PATENT APPLICATION

Application number: **89119543.0**

Int. Cl.5 **H03M 11/00 , B41J 5/10**

Date of filing: **20.10.89**

Date of publication of application:
**04.04.90 Bulletin 90/14**

Designated Contracting States:
**AT BE CH DE ES FR GB GR IT LI LU NL SE**

Applicant: **Kaiser, Thomas, Dr.**
**Gruobstrasse 3**
**CH-6372 Ennetmoos(CH)**

Inventor: **Kaiser, Thomas, Dr.**
**Gruobstrasse 3**
**CH-6372 Ennetmoos(CH)**

Representative: **von Bezold, Dieter, Dr. et al**
**Dr. Dieter von Bezold Dipl.-Ing. Peter Schütz**
**Dipl.-Ing. Wolfgang Heusler Brienner Strasse**
**52**
**D-8000 München 2(DE)**

## A data processing system input device.

An input device for a data processing system, such as a computer or a word processor, consists of a keyboard and an associated electronic circuitry. The keyboard consists of a left and a right array of keys mechnically separated from each other and therefore arbitrarily positionable relative to each other. The keys are couplable to coding units generating the code signals necessary for the control of a data processing facility connected to the keyboard. The two arrays of keys, both essentially of the same size, contain all the keys necessary for the input of data into the data processing facility and for the control of certain functions including a cursor. In addition to the usual switching device for the choice of capital and small letters and the like, there is an additional switching device so that a number of keys can be coupled alternatively to three or four different coding units. The electronic circuitry includes the switching devices and coding unit arrangement which in turn contain the coding units. Each switching device contains logical gates and a bistable circuit for latching the chosen relection of the coding units.

FIG. 5

# A DATA PROCESSING SYSTEM INPUT DEVICE

The present invention relates to an input device for a data processing system such as a computer or a word processing machine.

The present input device includes a keyboard and electronic circuitry associated to the keyboard. The keyboard permits a fully blind and rhythmic access for human fingers without an auxiliary keyboard for feeding data into the data processing system. The keyboard is divided into a left and a right array of keys each including a plurality of data keys having the functions of character, numeral and symbol keys, a space key and a first shift key. The data keys, the space key, the first shift key of both of that right and left arrays together, a "carriage return" or enter key in at least one of said arrays of keys and a further first shift key in one of said arrays of keys constitute and provide all functions of a given national standard keyboard for typewriters The keyboard further comprises a second shift key which is preferably positioned in the right array of keys which in combination with any of the first shift keys allows to assign three or preferably four function levels for at least some of the keys of the keyboard. Function levels which can be established by means of the second shift key include control functions of the data processing facility including those for a cursor control.

The present invention relates primarily to the electronic circuitry associated to the keyboard. The electronic circuitry disclosed herein is simple, reliable and space-saving.

Two preferred embodiments of the keyboard and one preferred embodiment of the electronic circuitry of the present input device will be described in the following with reference to the drawings, in which

Figs. 1 and 2 are simplified plane views of a left and a righ part ("half") of a keyboard, respectively, of a first preferred keyboard design according to the invention,

Figs. 3 and 4 are simplified plane views of a left and a right part of a keyboard, respectively, of a second preferred keyboard design according to the invention;

Fig. 5 is a somewhat simplified circuit diagram in block form of an overall electronic system suitable for the keyboards according to Figs. 1 and 2 or 3 and 4;

Fig. 6 is a circuit diagram, partly in block form, of a key switch of the electronic system shown in Fig. 5;

Fig. 7 is a circuit diagram in block form of a first switching device of the system shown in Fig. 5;

Fig. 8 is a circuit diagram in block form of a first switching device of the system of Fig. 5, and

Fig. 9 is a circuit diagram, partly in block form, of coding unit means of the system of Fig. 5.

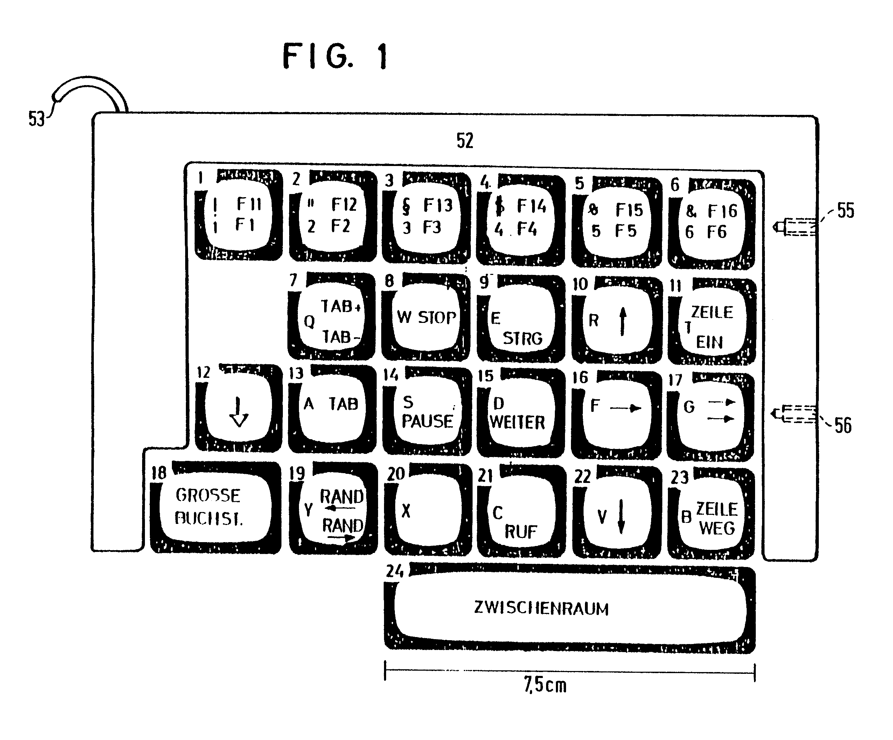

The embodiments of the keyboard shown in Figs. 1 to 4 are based on the German standard key assignment.

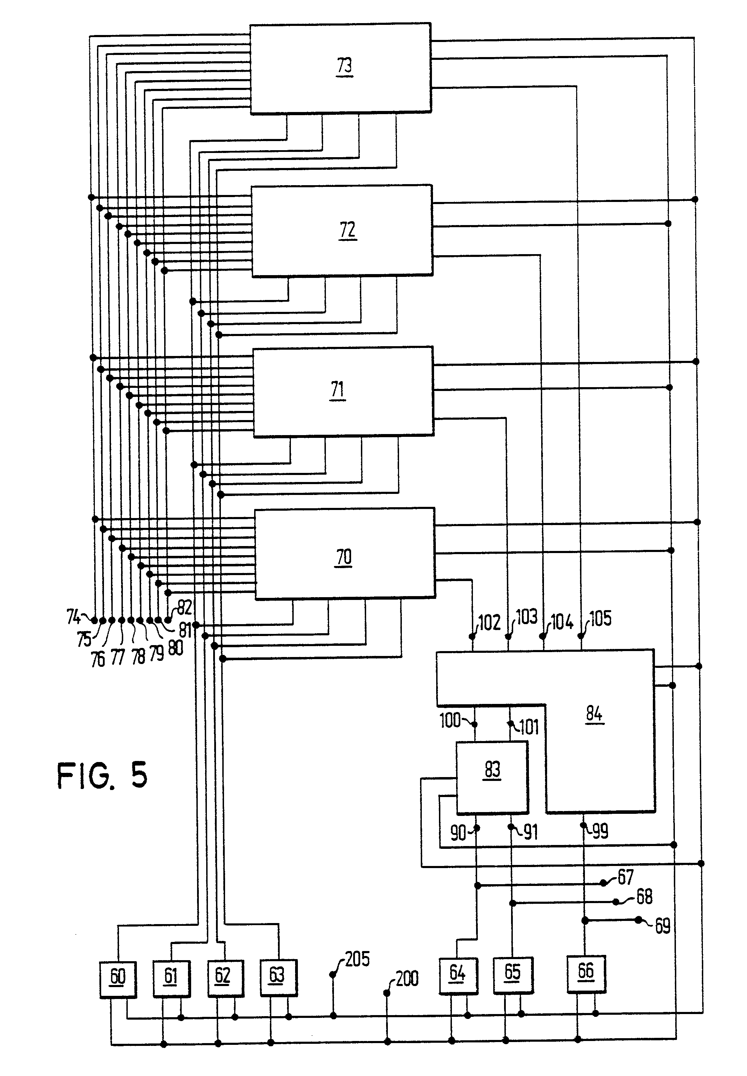

In the following description of the keyboards it is assumed that each key is provided with a contact mechanism, i.e. a key switch, which generates a signal of key actuation when the key is hit. Details of the key switches and the associated electronic circuitry will be described with reference to Figs. 5 to 9.

In the following description of the invention it is assumed that each key is combined with a contact mechanism, generating a signal of key actuation as soon as the key is hit. After having passed a contact bounce eliminator circuit and a switching device, the signal of key actuation usually activates a coding unit selected by the switching device; when activated by the signal of key actuation, the coding unit generates a specific code signal being recognized by the connected data processing facility, and causing the input of an alphameric or other character or the control of a function of the data processing facility. In the following, for simplicity, it will be referred exclusively to the key functions controllable by the respective keys.

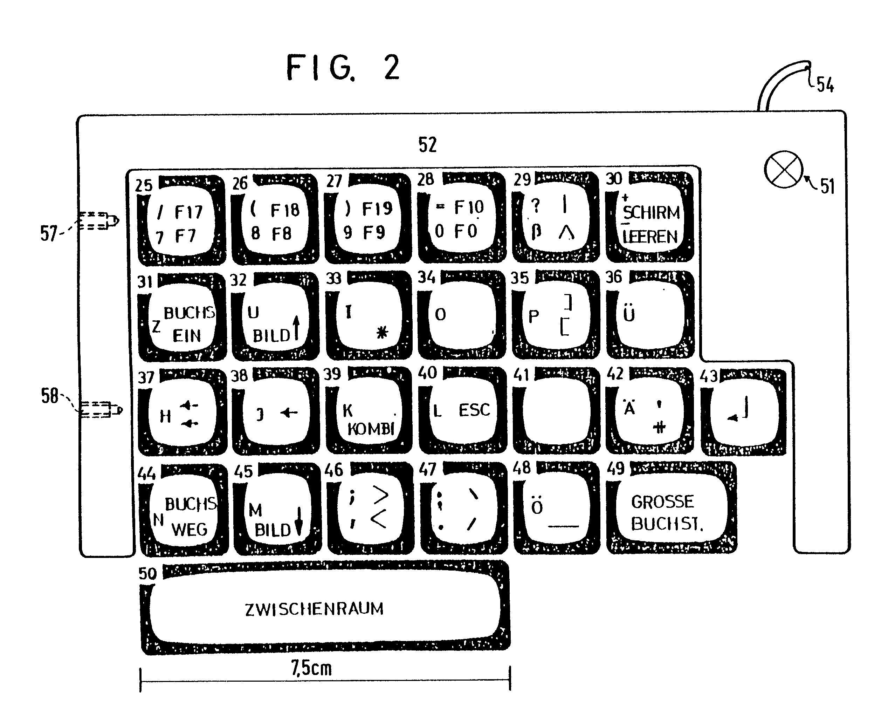

In the keyboard design according to fig. 1 and 2, the keys are arranged essentially in an orthogonal array, i.e. the keys align as well as in horizontal as well as in vertical direction.

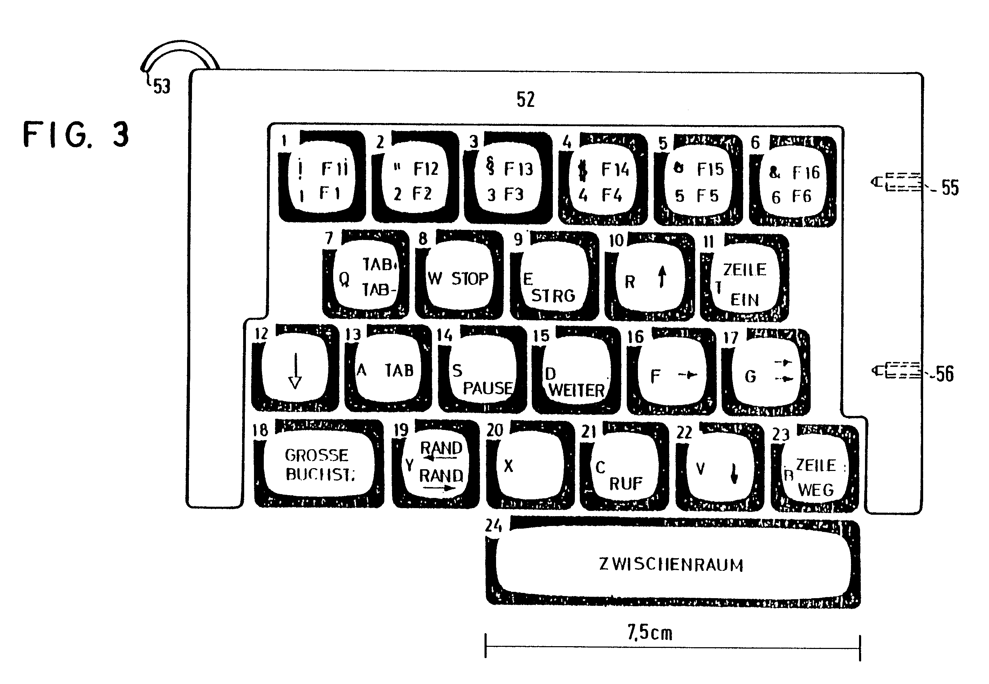

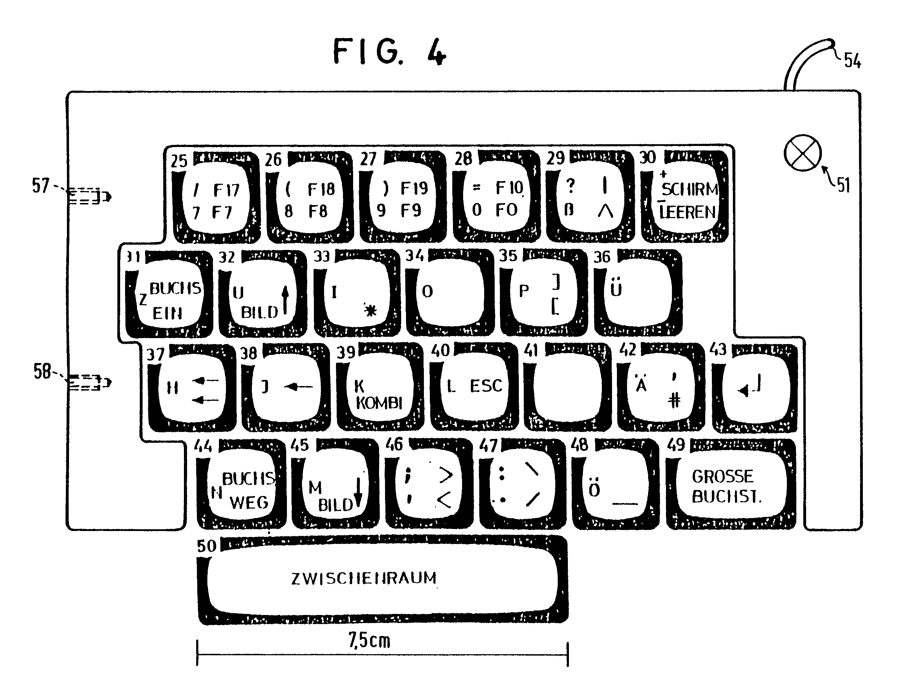

In the keyboard design according to fig. 3 and 4, the keys are staggered in adjacent horizontal rows as in the usual mechanical keyboards for typewriters having a fixed arrangement of keys.

In both cases the two parts of a keyboard are preferably movable relative to each other. In particular the two parts of a keyboard are mechanically separated so that they can be placed arbitrarily relative to each other. Because of the mutual mobility of the two parts, they may be rotated arbitrarily relative to each other which eliminates a source of obstruction of the fingers occurring in conventional typewriters. Therefore the design according to fig. 1 and 2 is preferred.

As a support for the beginner, the two parts of the keyboard are surrounded by a border along three sides, namely along the right, the left and the upper edge, the border rising e.g. 4 cm over the surface of the keys. This border is to facilitate particularly the task of locating blindly the keys of the uppermost row which are, by experience, particularly difficult keys to be hit blindly. From the edges (52) bundles (53, 54) of electrical signal and current supply lines lead to the connected data processing facility and a CRT terminal, respectively. Furthermore in the carrying frames there are threads for screws (55 to 58) enabling the left and the right part of the keyboard to be joined rigidly by means of a bridge of arbitrary shape in an arbitrary geometrical arrangement.

For facilitating the adaptation of the user to the new bipartite keyboard, one of the national standard key assign ments is adopted essentially unchanged (in the examples of figs. 1 to 4 it is the German key assignment) for two operational states of the keyboard (levels of designation). These first two operational states can be set by means of each of three first shift keys (12), (18) and (49) in a conventional way for all the data keys (characters, numerals, symbols) of both parts of the keyboard at once. In order to ensure the highest possible switching rate for setting the other two operational states (levels of designation), the slow thumb is to be excluded from being used as a possible switching tool. Therefore only the initial position of the eight other fingers is usable. In order to keep the sacrifice of the corresponding character to be moved for that purpose as small as possible, key (41) in fig. 2 and 4 (in the German keyboard the conventional ö-key) is used as a second shift key; key (41) corresponds to the initial position of the little finger of the right hand. In order to impair a reliable hitting of symbols displaced from key (41) as little as possible, the symbols are settled anew in an optimal way. In the case of the German keyboard, the character "ö" is assigned to key (48) in fig. 2 and 4, which drives the hyphen and the underlining out of their traditional places. Underlining is now provided by key (48) when actuated in the third operational state of the keyboard (third level of designation); this is to be considered a progress, as in most cases, underlining is combined closely with cursor movements to be controlled in the third operational state of the keyboard as well. In order to facilitate the use of the hyphen during the usual typing of texts using the first and second operational state of the keyboard ( first and second level of designation) in the conventional way, the hyphen is assigned to key (30) in the first operational state; key (30) should be easily locatable by aid of the border (52) mentioned above.

There is a lamp (51) in the right part of the keyboard according of fig. 2 and 4 for indicating the second switching device being activated by the second shift key (41); when turned on, the lamp also indicates the active operational state of the second switching device. The second switching device controlled by key (41) is bistable, and its design is such that each actuation of key (41) causes a reversal of the operational state of this switching device. Key (41) is of a preferably loud, e.g. red colour and is not labeled. All the other keys are preferably of a light colour (a light gray or light beige). In order to ensure that keys (41; 18, 49, and 12) have control of both parts of the keyboard at the same time, two additional signal lines are necessary leading from the right part of the keyboard to a point of convergence of the cables of the two parts of the keyboard and from there on further to the left part of the keyboard. Accordingly, either the digital signal level 0 or 1 ( = switching signal) is held on these signal lines at any time, and indicates, if the switching device concerned is in an activated operational state or at rest.

In the figures 1 to 4 the keys are labeled according to the proper coding functions effective in the different operational states to be set by using the three first shift keys (12, 18, 49) and the second shift key (41). The operational state of the first switching device can be reversed bistably i.e. locked using key (12), whereas the keys (18) and (49) can only activate the second operational state as long as they are pressed down. In the first operational state of the keyboard (S/U) none of the switching devices is in an activated operational state (switching signal 0,0). The second operational state (S/O) is set by actuating of one of the first shift keys (12), (18) or (49), the second switching device being at rest (switching signal 1,0). The third operational state (R/U) is with the first switching device being at rest and the second switching device in an activated operational state (switching signal 0,1). The fourth operational state (R/O) is with both switching devices being in an activated operational state (switching signal 1,1). The change between both of the conventional first operational states (S/U) and (S/O) occurs as in the past, when one of the first shift keys (12), (18) or (49) is actuated.

It is advantageous, if a keyboard still offers some empty space for including further special symbols and/or functions. Therefore, at present, not all the keys are assigned to four coding units in this keyboard. The keys (12, 24 and 43) keep the same respective coding unit in all four operational states. Other keys have coding units but in the first and second operational state. Finally there are keys which can be connected arbitrarily to one of three coding units. To sum up, it can be said that, preferably, only as many keys are connected to four different coding units as needed to support

    1) a complete national standard keyboard,

    2) all the additional symbols for programming e.g. in the computer language "Basic",

    3) commands for the control of tabulator and row delimiter marks,

    4) commands for cursor movements,

    5) eight further control commands,

6) twenty programmable functions (F0) to (F19).

An easy control of the cursor was considered to be of great importance. Therefore, in this keyboard, the movement of the cursor is controlled by keys comprised in one of the two single arrays of keys of the keyboard and particularly by keys to be actuated exclusively and comfortably by the two index fingers ( 10, 11, 16, 17, 22, 23, 31, 32, 37, 38, 44, 45). Moreover, the movement of the cursor corresponds to a large extent to the movement of the tip of the index finger when actuating a key for generating a command for moving the cursor: The right index finger moves the cursor to the left, left index finger moves the cursor to the right.

In the examples of keyboards designed as shown in figs. 1 to 4 and based on the German standard key assignement, the different keys are used in the four different operational states (S.U), (S.O). (R U), and (R/O), respectively, corresponding to the switching states 0,0; 1,0; 0,1; 1,1; respectively, and connected to the following coding units, identified by the object of the corresponding code signal and by the function controlled by the code signal, respectively:

Key 1:
(S.U): Numeral 1
(S.O): Exclamation mark
(R,U): Function key 1
(R.O): Function key 11

Key 2:
(S,U): Numeral 2
(S.O): Quotation mark
(R.U): Function key 2
(R,O): Function key 12

Key 3:
(S,U): Numeral 3
(S,O): Paragraph
(R.U): Function key 3
(R.O): Function key 13

Key 4:
(S,U): Numeral 4
(S,O): Dollar signal
(R,U): Function key 4
(R,O): Function key 14

Key 5:
(S,U): Numeral 5
(S,O): %-signal
(R,U): Function key 5
(R,O): Function key 15

Key 6:
(S,U): Numeral 6
(S,O): &-signal
(R,U): Function key 6
(R,O): Function key 16

Key 7:
(S,U): q
(S,O): Q

(R.U): TAB -: Clearing a tabulator mark at the actual position of the cursor
(R,O): TAB +: Setting a tabulator mark at the actual position of the cursor

Key 8:
(S,U): w
(S,O): W
(R,U): STOP: Unconditional abort of the current program; returning control to the keyboard
(R,O):

Key 9:
(S,U): e
(S,O): E
(R,U): STRG: Control key. (Examples: Controlling difficult program interrupts, commanding to clear parts of main memory, and other system commands in combination with the subsequent actuation of a second key in level of designation 3).
(R,O):

Key 10:
(S,U): r
(S,O): R
(R,U): Arrow pointing upwards: Moving the cursor upwards by one line.
(R,O):

Key 11:
(S,U): t
(S,O): T
(R,U): ZEILE EIN: Creating space for one more line above the line of the cursor.
(R,O):

Key 12:
(S,U): Locking keys 18 or 49 ( = Selecting capital letters and upper symbols, respectively).
(S,O): Locking keys 18 or 49 ( = Selecting capital letters and upper symbols, respectively).
(R,U): Locking keys 18 or 49 ( = Selecting capital letters and upper symbols, respectively).
(R/O): Locking keys 18 or 49 ( = Selecting capital letters and upper symbols, respectively).

Key 13:
(S/U): a
(S,O): A
(R,U): TAB: Moving the cursor to the following tabulator mark.
(R/O):

Key 14:
(S/U): s
(S/O): S
(R/U): PAUSE: Interrupting current program for a pause.
(R/O):

Key 15:
(S/U): d
(S/O): D
(R/U): WEITER: Resuming a current program after a pause.
(R/O):

Key 16:
(S/U): f
(S/O): F
(R/U): Arrow pointing to the right: Moving the cursor one step to the right.
(R/O):
Key 17:
(S/U): g
(S/O): G
(R/U): Double arrow pointing to the right: Moving the cursor to the end of the line.
(R/O):
Key 18:
(S/U): GROSSE BUCHSTABEN: Selecting capital letters and upper symbols, respectively, on keys.
(S/O): GROSSE BUCHSTABEN: Selecting capital letters and upper symbols, respectively, on keys.
(R/U): GROSSE BUCHSTABEN: Selecting capital letters and upper symbols, respectively, on keys.
(R/O): GROSSE BUCHSTABEN: Selecting capital letters and upper symbols, respectively, on keys.
Key 19:
(S/U): y
(S/O): Y
(R/U): RAND → : Setting the right line delimiter mark at the cursor position.
(R/O): ← RAND: Setting the left line delimiter mark at the cursor position.
Key 20:
(S/U): x
(S/O): X
(R/U):
(R/O):
Key 21:
(S/U): c
(S/O): C
(R/U): RUF: Fetching last input command onto the CRT screen.
(R/O):
Key 22:
(S/U): v
(S/O): V
(R/U): Arrow pointing downwards: Moving the cursor downwards by one line.
(R/O):
Key 23:
(S/U): b
(S/O): B
(R/U): ZEILE WEG: Erasing the line of the cursor; then closing the gap of the text.
(R/O):
Key 24:
(S/U): ZWISCHENRAUM ( = Space)
(S/O): ZWISCHENRAUM ( = Space)
(R/U): ZWISCHENRAUM ( = Space)
(R/O): ZWISCHENRAUM ( = Space)
Key 25:
(S/U): Numeral 7

(S/O): Division signal
(R/U): Function key 7
(R/O): Function key 17
Key 26:
(S/U): Numeral 8
(S/O): (-signal
(R/U): Function key 8
(R/O): Function key 18
Key 27:
(S/U): Numeral 9
(S/O): )-signal
(R/U): Function key 9
(R/O): Function key 19
Key 28:
(S/U): Numeral 0
(S/O): = -signal
(R/U): Function key 0
(R/O): Function key 10
Key 29:
(S/U): β
(S/O): ?-signal
(R/U): ^ -signal
(R/O): |-signal
Key 30:
(S/U): Hyphen (minus sign)
(S/O): + -signal
(R/U): SCHIRM LEEREN: Erasing the content of the CRT screen.
(R/O):
Key 31:
(S/U): z
(S/O): Z
(R/U): BUCHST.EIN: Creating space for inserting a character one step to the left of the cursor position.
(R/O):
Key 32:
(S/U): u
(S/O): U
(R/U): BILD ↑ : CRT screen: Moving text quickly downwards: Arrow indicating earlier parts of text getting accessible to the user.
(R/O):
Key 33:
(S/U): i
(S/O): I
(R/U): Star (Multiplication sign)
(R/O):
Key 34:
(S/U): o
(S/O): 0
(R/U):
(R/O):
Key 35:
(S/U): p
(S/O): P
(R/U): [-signal
(R/O): ]-signal
Key 36:

(S U): ü
(S O): Ü
(R U):
(R O):
    Key 37:
(S U): h
(S O): H
(R U): Double arrow pointing to the left: Moving the cursor to the left line delimiter.
(R O):
    Key 38:
(S U): j
(S O): J
(R U): Arrow pointing to the left: Moving the cursor to the left by one step.
(R O):
    Key 39:
(S U): k
(S O): K
(R U): KOMBI: Combination key: For generating rare characters and symbols (Extended ASCII), being used in combination with a subsequent actuation of one or two additional keys in (R U) (may be in (R O)).
(R O):
    Key 40:
(S U): 1
(S O): L
(R U): ESC: Escape key for generating "escape" sequences.
(R O):
    Key 41:
(S U): The red shift key
(S O): The red shift key
(R U): The red shift key
(R O): The red shift key
    Key 42:
(S U): ä
(S O): Ä
(R U): #-signal
(R O): '-signal
    Key 43:
(S U): "Carriage return" = Storing lines and executing command, respectively ("RETURN")
(S O): "Carriage return" = Storing lines and exexuting command, respectively ("RETURN")
(R U): "Carriage return" = Storing lines and executing command, respectively ("RETURN")
(R O): "Carriage return" = Storing lines and executing command, respectively ("RETURN")
    Key 44:
(S U): n
(S O): N
(R U): BUCHS.WEG: Erasing character at cursor position: then moving the cursor by one step to the left.
(R O):
    Key 45:

(S U): m
(S O): M
(R U): BILD ↓ : CRT screen: Moving text quickly upwards: Arrow downwards indicating parts of the text below getting accessible to the user.
(R O):
    Key 46:
(S U): Comma
(S O): Semicolon
(R U): <-signal
(R O): >-signal
    Key 47:
(S U): Period
(S O): Colon
(R U): French ´-accent
(R O): French ` -accent
    Key 48:
(S U): ö
(S O): Ö
(R U): Underlining
(R O):
    Key 49:
(S U): GROSSE BUCHSTABEN (As for key 18)
(S O): GROSSE BUCHSTABEN (As for key 18)
(R U): GROSSE BUCHSTABEN (As for key 18)
(R O): GROSSE BUCHSTABEN (As for key 18)
    Key 50:
(S U): ZWISCHENRAUM ( = Space)
(S O): ZWISCHENRAUM ( = Space)
(R U): ZWISCHENRAUM ( = Space)
(R O): ZWISCHENRAUM ( = Space)

As what the other national keyboards are concerned, the national standard keyboards for typewriters are realized by aid of the switching states (S U) and (S O), whereas the keys in the switching states (R U) and (R O) are assigned essentialy to the same coding units as described for the German keyboard.

However, there are deviations resulting from the reservation of key (41) for the second switching device, from these assignments of (S U), (S O), (R U), and (R O), in several national keyboards. The proposed changes are such that the interference with the key assignment of the respective national standard keyboards for typewriters is kept minimal. These changes are described below for the following, national keyboards:

France:

    1) M is moved to (S U) and (S O) of key (45).
    2) Question mark and comma are moved to (S O) and (S U), respectively, of key (48).
    3) Plus sign is moved to (S/O) of key (30).
    4) Underlining is moved to (R/U) of key (30).
    5) Equal sign is moved to (R/U) of key (33).

Great Britain:

1) Plus sign and hyphen are moved to (S O) and (S U), respectively of key (30).

2) 1 4 and 1 2 are moved to (R O) and (R/U), respectively, of key (30)

3) Semicolon is moved to (S/U) of key (29).

4) Underlining is moved to (R U) of key (29).

Italy:

1) M is moved to (S U) and (S O) of key (45).

2) Question mark is moved to (S U) of key (6).

3) Underlining is moved to (R U) of key (6).

4) Comma is moved to (S U) of key (46).

5) Semicolon is moved to (S O) of key (46).

6) Apostrophe is moved to (R/U) of key (33).

7) Star (multiplication sign) is moved to (R U) of key (34).

Switzerland, German and French

1) Mutated vovels of key (41) are moved to (S U) and (S O) of key (48).

2) Underlining is moved to (R/U) of key (48).

3) Hyphen is moved to (R U) of key (33).

Spain:

1) Ñ is moved to (S U) and (S O) of key (48).

2) Underlinign is moved to (R/U) of key (48).

3) Hypphen (minus sign) is moved to (R/U) of key (33).

4) Plus sign is moved to (R/U) of key (34).

5) Star (multiplication sign) is moved to (R/U) of key (36).

The United States of America:

1) Colon and semicolon are moved to (S/O) and (S/U), respectively, of key (29).

2) Underlining is moved to (R/U) of key (29).

3) Hyphen is moved to (S/U) of key (30).

4) Equal sign is moved to (R/U) of key (33).

In addition, these keyboards may include a repeating automatism: Either it may be activated by aid of a special repeating key to be placed in the empty space between keys (1), (7) and (12) of fig. 1, and to be used in all four levels of designation; or a waiting automatism is used activating the repetition as soon as a key is held down longer than a certain interval of time.

The empty space over key (43) ( = "carriage return") may be used to lengthen key (43) in this direction.

The definitions of national key assignements, as used here, are from the booklet "Professional User's Guide Hard Disc System", AA-N603C-TH of the company Digital Equipment Corporation, 1984.

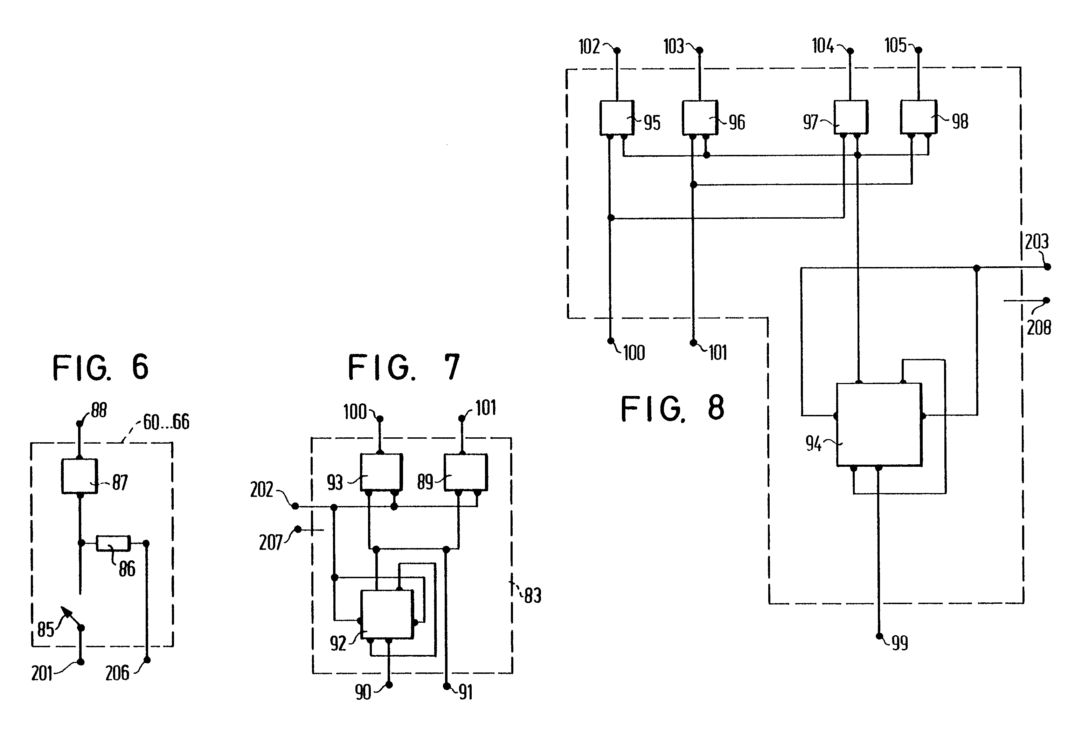

Figure 5 is a block diagram of a preferred electronic system associated to the arrays of keys in each half of the keyboard. The system comprises a plurality of key switches 60 to 66 which contain contact means for generating a signal of key actuation (key signal) when the key switch means is actuated by the corresponding key of the keyboard. The key switches 60 to 66 are all alike; a preferred embodiment thereof is shown in Figure 6.

Each key switch 60 to 66 is associated to a different key of the keyboard (Figures 1 to 4). Thus, a first plurality of key switches is associated to the data keys (alphanumerical keys) 1·to 11, 13 to 17, 19 to 23, 25 to 40, 42 and 44 to 48 of the two halves of the keyboard shown in Figures 1 to 4. Only four key switches 60 to 63 of these many key switches are shown in Fig. 5 for the sake of clarity. Further key switches (not shown) are associated to the space keys 24 and 50 and the CARRIAGE RETURN or ENTER key 43.

Key switch 65 is associated to the first shift key 18 and 49, respectively, of the left and right halves of the keyboards of Figures 1 to 4. Key switch 64 is associated to the further first shift key 12 and thus, is present only in the electronic system associated to the left half of the keyboard.

Key switch 66 is associated to the second shift key 41 positioned in the right half of the keyboard and, thus, present only in the electronic system associated to the right half of the keyboard. Both key switches 64 and 66 are shown in Fig. 5 for facilitating the description of the system.

The outputs of key switches 64 and 65 are coupled to terminals 90, 91, respectively, of a first switching device 83 shown in more detail in Fig. 7. The first switching device 83 provides first and second output signals to first and second terminals 100, 101, respectively, of a second switching device 84 which is shown in more detail in Fig. 8. The second switching device 84 receives a further input at an input terminal 99 from key switch 66.

Since the keys 12, 18 and 41, 49 are located in different halves of the keyboard and since the signals provided by the corresponding key switches 64 to 66 have to be made effective in the electronic systems of both halves of the keyboard, signal lines including connectors 67, 68 and 69, respectively, are provided which couple the outputs of the key switches 64, 65, 66 to the switching device inputs 90, 91 and 99, respectively of the electronic systems of both halves of the keyboard.

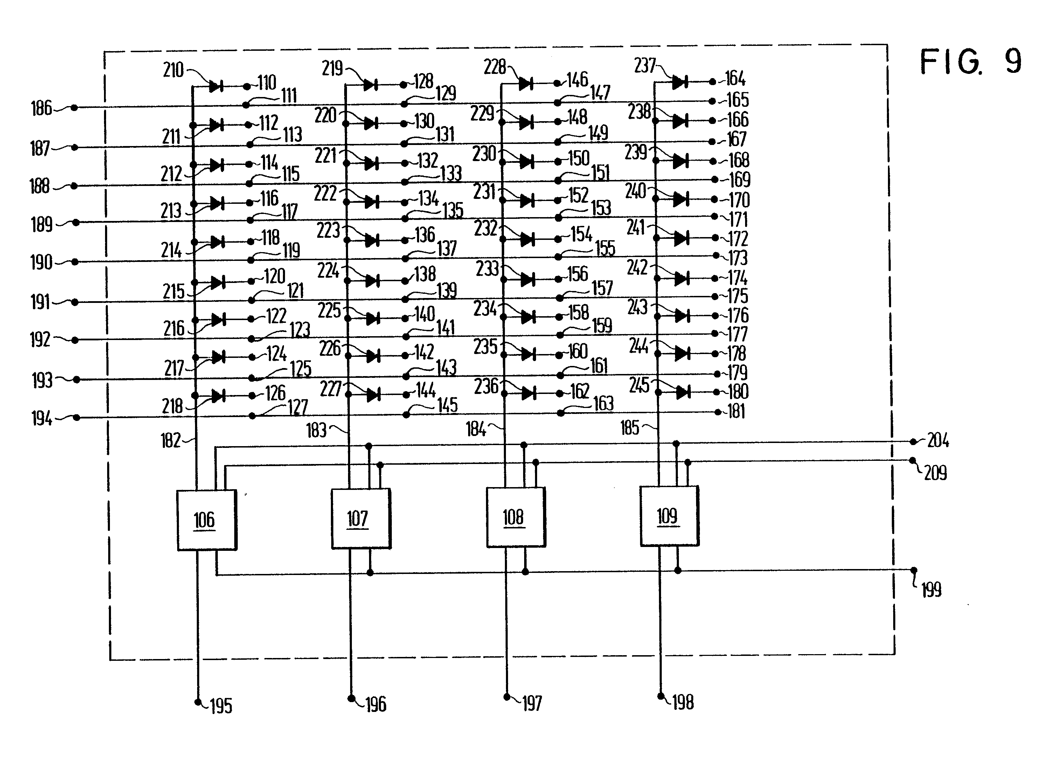

The system of Fig. 5 further comprises coding unit means 70, 71, 72 and 73. Each coding unit means comprises one set of coding units for each data key switch. A typical preferred circuit diagram of a coding unit means is shown in Fig. 9. Since only four data key switches 60 to 63 are shown in Fig. 5 only four coding units are shown in Fig. 9. In practice, each coding unit means 70 to 73 may contain at least twentytwo coding units. Actuation of a code unit by a key signal generates a code signal for the data processing facility controlled by the present input system. In a preferred embodiment, the code signal is a 9-bit signal available on output terminals 70 to 74 in Fig. 5. Preferably, the ASCII code assignment is used with a parity bit which appears on output terminal 82. In operation, the terminals 74 to 82 are coupled to a data bus of the associated data processing facility.

The first switching device 83 is responsive to each first shift key 12, 18, and 49. It permits coupling the outputs of the key switches of the data keys, i.e. of the key switches 60 to 63 ... in both halves of the keyboard alternatively to the coding units in the first coding unit means 70 or the second coding unit means 71. The coding units in these coding unit means 70 and 71 are capable of generating all code signals for the complete alphanumeric character set and auxiliary functions (space, carriage return and the like) of a given national standard keyboard for typewriters as explained with reference to Figures 1 to 4. The second switching device 84 which is controlled by the second shift key 41 via key switch 66 allows to couple the outputs of at least some of the data key switches 60 to 63.. to code units in at least a third coding unit means 72; preferably, in combination with the first switching device 83 selectively to code units in the third code unit means 72 and the fourth code unit means 73. The code unit means 72 and 73 comprise code units which produce code signals for the control of functions of the data processing facility including code signals for the control of a cursor. It is an essential feature of the present invention that the cursor is controllable by data keys rather than by keys individually assigned to the cursor control.

Fig. 6 shows a circuit diagram of a key switch. The key switch of Fig 6 includes contact means 85, arranged to be closed by striking the associated key. One terminal of the contact means 85 is coupled to a terminal 201 for an operating potential of e. g. 5V. The other terminal of the contact means 85 is coupled via a resistor 86 to a terminal 206 connected to ground and to an anti-bouncing device 87, e.g. a Schmitt trigger or preferably a monostable multivibrator (e. g. S. N. 74121 manufactured by Texas Instruments). The output of the device 87 is applied to an output terminal 88 of the key switch. The monostable multivibrator makes the output signal of the key switch independet of the duration of the key stroke and eliminates adverse effects of contact bouncing.

Fig 7 shows a preferred circuit diagram of the first switching device 83 of Fig. 5. It contains a flipflop 92 (e g. type 7474 Texas Instruments) having an input connected to the key switch 64 via the input terminal 90, an output coupled to first input terminals of an AND gate 89 and an Exclusiv-OR ("XOR") gate 93. The second inputs of the gates 89 and 93 are coupled to an operating potential terminal 202 providing a potential corresponding to a logical 1. The first input terminals of the gates 89 and 93 are further coupled to the outputs of the key switches 65 via the terminal 91.

AND gate 89 provides an output to terminal 101. XOR gate 93 provides an output to terminal 100. It should be obvious that the first switching device 83 provides a logical 1 at the output terminal 100 and a logical zero at terminal 101 at all times unless a first shift key actuates a logical 1 at the terminal 101 and a logical zero at the terminal 100. The flipflop 87 provides the further first shift key 12 with a bistable or locking function, i. e. each actuation of the shift key 12 alters the state of the output signals at the terminals 100 and 101.

Figure 8 shows a preferred circuit diagram of the second switching device 84. It contains a flipflop 94 (e. g. type 7474) having an input coupled via terminal 99 to key switch 66 actuated by the second shift key 41. Each actuation of the second shift key 41 changes the state of the flipflop 94. The output of the flipflop 94 is a logical 1 when the flipflop is set.

The signal from the terminal 100 of the first switching device 83 is applied to a first input terminal of an XOR gate 95 and an AND gate 97. The signal from the terminal 101 of the first switching device is applied to first input terminals of an XOR gate 96 and an AND gate 98. The output of the flipflop 94 is applied to second input terminals of the XOR gates 95 and 96 and the AND gates 97 and 98. Thus, when the flipflop 94 is reset, the output signals from the gates 89 and 93 of the first switching device 83 pass through to output terminals 103, 102, respectively, which in turn are coupled to coding units 71, 70, respectively. When the flipflop 94 is set, the XOR gates 95 and 96 are disabled and the output signals from the terminals 100 and 101 pass through the AND gates 97, 98, respectively, to output terminals 104, 105, respectively, which in turn are coupled to coding unit means 72, 73, respectively. Flipflop 94 allows for a bistable mode of operation of second shift key 41 of Figures 2 and 4.

Fig. 9 shows a circuit diagram, partially in block form, of a code unit 70 to 73. It comprises an AND gate 106, 107, 108, 109... for each data key in the keyboard. A first input terminal of each AND 106 to 109 is coupled to the output of a corresponding key switch via an input terminal 195, 196, 197, and 198, respectively. Second input terminals of the AND gates 106 to 109 are coupled to an input terminal 199 which receives a signal from a corresponding one of the terminals 102 to 105 of the second switching device 84. Each AND gate 106 to 109 has an output coupled to a corresponding output line 182, 183, 184 and 185, respectively, each leading to a corresponding code unit. The first code unit which is controlled by the signal on line 182 comprises protective diodes 210 to 218 and pairs of contacts 110, 111; 112, 113, ... to 126, 127, by which the line 182 can be selectively coupled to each of nine output terminals 186 to 194 which are coupled to the terminals 74 to 82, respectively, of Fig. 5. Similarily the second to third coding units comprise diodes 219 to 227, 228 to 236, 237 to 245, respectively, and pairs of contact 128 to 145, 146 to 163 and 164 to 181, respectively. The coding units in Fig 9 are shown in their virgin state. They are programmed by permanently bridging selected contact pairs 110, 111, ... 180, 181 so that a predetermined individual code signal appears on the terminals 196 to 194 when one of the lines 182 to 185 is selected. Throughout in Figures 5 to 9 terminals 200 to 204 are operating potential input terminals receiving an operating potential of e. g. +5V from the associated data processing facility. Terminals 205 to 209 are ground terminals coupled to ground of the data processing facility.

The circuitry described with reference to Figs. 5 to 9 can be implemented by customer designed integrated circuits so that they need very little space.

## Claims

1. A data processing system input device including a keyboard and electronic circuitry associated to said keyboard, said keyboard permitting a fully blind and rhythmic access for actuating human fingers without an auxiliary keyboard for feeding data into a data processing facility,
said keyboard comprising
- a left and a right array of keys each array including a plurality of data keys having the functions of character, numeral and symbol keys, a space key and a first shift key; said data keys, space key and first shift keys of both of said right and left arrays together, a "carriage return" key in at least one of said arrays of keys and a further first shift key in one of said arrays of keys essentially constituting and providing all functions of a given standard keyboard for typewriters;
- a second shift key;
said electronic circuitry comprising
- a plurality of key switches each associated to one of said keys and including contact means actuable by the corresponding key for generating a key actuation signal when the corresponding key is actuated;
- a plurality of coding unit means each comprising a plurality of coding units; each coding unit being responsive to a key actuation signal to generate a code signal representing a specific key function for the control of the data processing facility when actuated by a key actuation signal;
- a first switching device responsive to all first shift keys and being operative for coupling the contact means of the data keys of both arrays of keys alternatively to a first or a second coding unit means both of which together being capable of generating code signals for the complete alphanumeric character set and auxiliary functions of said standard keyboard for typewriters;
- a second switching device controlled by said second shift key for coupling at least some of the contact means of said data keys at least to a third coding unit means which includes code units being capable of generating code signals for controlling functions of the data processing facility including those for a cursor control;
- said first switching device comprising a bistable circuit actuable by a signal of key actuation from said further first shift key for alternatively producing first and second output signals for selecting alternatively said first or second coding unit means to enable the selected coding unit means to be responsive to key actuation signals, and further comprising gate means for producing said first signal only when no shift key is actuated, and providing said second signal when one of said shift keys is actuated;
- said second switching device comprising a second bistable device having an input coupled to the key switch of said second shift key for receiving a signal which changes the state of said bistable device, each time when said second shift key is actuated; said second switching device further comprising gate means coupled to an output of said second bistable device and receiving said output signals from said first switching device, said gate means being arranged to pass said first and second signals from said first switching device to said first and second coding unit means, respectively when said second bistable device is in a first state, and passing at least said first signal to said third coding unit means to enable said coding unit means to respond to key actuation signals when said bistable device is in a second state of operation.

2. The system as claimed in claim 1, wherein said gate means of said second switching device is arranged to pass said second signal from said first switching device to a forth coding unit means to enable said forth coding means to respond to key actuation signals when said flipflop of said second switching device is operating in its second state of operation, said fourth coding unit means comprising coding units for producing code signals for controlling functions of the data processing facility.

# FIG. 1

EP 0 361 533 A2

# FIG. 2

| | | | | | |
|---|---|---|---|---|---|
| **25** / F17 7 F7 | **26** ( F18 8 F8 | **27** ) F19 9 F9 | **28** = F10 0 F0 | **29** ? \| β ∧ | **30** + SCHIRM − LEEREN |
| **31** Z BUCHS EIN | **32** U BILD↑ | **33** I * | **34** O | **35** P ] [ | **36** Ü |
| **37** H ↔ | **38** J ← | **39** K KOMBI | **40** L ESC | **41** | **42** Ä ' # | **43** ↵ |
| **44** N BUCHS WEG | **45** M BILD↓ | **46** ; > , < | **47** : ' . / | **48** Ö ___ | **49** GROSSE BUCHST. |

**50** ZWISCHENRAUM

7,5cm

EP 0 361 533 A2

# FIG. 3

EP 0 361 533 A2

FIG. 4

54

51

57

58

| 25 / F17 7 F7 | 26 ( F18 8 F8 | 27 ) F19 9 F9 | 28 = F10 0 FO | 29 ? ! β ∧ | 30 + SCHIRM − LEEREN |

| 31 Z BUCHS EIN | 32 U ↑ BILD | 33 I * | 34 O | 35 P ] [ | 36 Ü |

| 37 H ← ← | 38 J ← | 39 K KOMBI | 40 L ESC | 41 | 42 Ä ' # | 43 ↵ |

| 44 N BUCHS WEG | 45 M BILD ↓ | 46 ; > , < | 47 : \ . / | 48 Ö __ | 49 GROSSE BUCHST. |

| 50 ZWISCHENRAUM |

7,5cm

EP 0 361 533 A2

FIG. 5

FIG. 8

FIG. 7

FIG. 6

FIG. 9